# EUROPÄISCHE PATENTSCHRIFT

(11) **EP 2 324 275 B1**
(45) Veröffentlichungstag und Bekanntmachung des Hinweises auf die Patenterteilung: **09.01.2013**
(21) Anmeldenummer: 09772562.6
(22) Anmeldetag: 03.07.2009
(51) Int. Cl.: F16P 3/12, H03K 17/955

(54) **BERÜHRUNGS- UND ANNÄHERUNGSERKENNUNG MIT KAPAZITIVEN SENSOREN**
CONTACT AND PROXIMITY DETECTION USING CAPACITIVE SENSORS
DÉTECTION DE CONTACT OU DE PROXIMITÉ AU MOYEN DE DÉTECTEURS CAPACITIFS

(30) Priorität: 04.07.2008 DE 102008031743
(43) Veröffentlichungstag der Anmeldung: 25.05.2011
(73) Patentinhaber: IDENT Technology AG, 82205 Gilching (DE)
(72) Erfinder: IVANOV, Artem, 82205 Gilching (DE)
(74) Vertreter: Grubert, Andreas
(86) Internationale Anmeldenummer: PCT/EP2009/058466
(87) Internationale Veröffentlichungsnummer: WO 2010/000862

(56) Entgegenhaltungen:
- WO-A1-2007/048639
- WO-A2-2009/153332
- DE-A1-102005 003 488
- US-A1- 2002 154 039

## Beschreibung

Die Erfindung betrifft eine Sensoreinrichtung zur Erfassung einer Annäherung eines Objekts in einem von der Sensoreinrichtung überwachten Observationsbereich.

Eine Sensoreinrichtung zur Erfassung einer Annäherung eines Objektes an die Sensoreinrichtung ist aus der DE 10 2005 003 488 A1 bekannt. Die Sensoreinrichtung ist als kapazitiver Sensor mit einer Überwachungseinrichtung ausgestaltet, wobei die Überwachungseinrichtung eine Kondensatorelektrode und eine Auswerte- und Steuerschaltung aufweist. Mittels der Auswerte- und Steuerschaltung kann die Kapazität der Kondensatorelektrode ermittelt werden, die durch ein Umgebungsmedium der Kondensatorelektrode oder ein Objekt in der Nähe der Kondensatorelektrode bestimmt ist. Mittels der Auswerte- und Steuerschaltung kann ein kodiertes Zugangsberechtigungssignal eingelesen werden, welches an der Kondensatorelektrode der Überwachungseinrichtung kapazitiv eingekoppelt werden kann. Das Zugangsberechtigungssignal kann von einem Identgeber bereitgestellt werden, welcher ebenfalls eine Kondensatorelektrode aufweist. Die Kondensatorelektroden der Überwachungseinrichtung und des Identgebers bilden zusammen einen Kondensator, über den das Zugangsberechtigungssignal kapazitiv übertragen werden kann.

Der Erfindung liegt die Aufgabe zugrunde, Lösungen aufzuzeigen durch welche die Präsenz von Objekten, insbesondere von Lebewesen, in dem vorgenannten Observationsbereich zuverlässig erfasst bzw. detektiert werden kann.

Gemäß der Erfindung bereitgestellt wird demnach eine Sensoreinrichtung zur Erfassung einer Annäherung eines Objekts in einem von der Sensoreinrichtung überwachten Observationsbereich, wobei die Sensoreinrichtung eine Serverschaltung aufweist mit
- einem LC-Schwingkreis mit einer Signalgeberschaltung, vorzugsweise einem LC-Schwingkreis hoher Güte, zur Erzeugung eines elektrischen Felds,
- einer mit dem LC-Schwingkreis gekoppelten Elektrodeneinrichtung, wobei die Kapazität der Elektrodeneinrichtung Bestandteil der SchwingkreisKapazität bildet und wobei das vom LC-Schwingkreis erzeugte elektrische Feld an der Elektrodeneinrichtung in den Observationsbereich abstrahlbar ist, und
- einer Auswerteeinrichtung,
wobei die Annäherung eines Objekts, insbesondere eines Lebewesens in den Observationsbereich der Elektrodeneinrichtung eine Änderung der kapazitiven Umgebung der Elektrodeneinrichtung bewirkt, welche von der Auswerteeinrichtung detektierbar ist.

Vorzugsweise ist die Signalgeberschaltung als Oszillator und der LC-Schwingkreis als LC-Serienschwingkreis ausgestaltet, wobei die Elektrodeneinrichtung parallel zum LC-Schwingkreis geschaltet ist. Der Oszillator und der LC-Serienschwingkreis können hierbei einen freilaufenden LC-Oszillator bilden.

Der LC-Schwingkreis kann auch als LC-Parallelschwingkreis ausgestaltet sein, wobei die Elektrodeneinrichtung seriell zum LC-Schwingkreis geschaltet ist.

Weitere Ausführungsformen des LC-Schwingkreises und der Anordnung der Elektrodeneinrichtung zum LC-Schwingkreise sind möglich.

Der LC-Serienschwingkreis hoher Güte führt zu einer effektiven Erhöhung der Spannungsamplitude an der Elektrodeneinrichtung, sowie zu einer erhöhten Empfindlichkeit zur Lastmodulation an dieser Elektrodeneinrichtung. Die hohe Güte des LC-Serienschwingkreises führt gleichzeitig dazu, dass dieser eine sehr stabile Frequenz erzeugt, die von den Werten der Induktivität und der Kapazität im Schwingkreis abhängt.

Die Sensoreinrichtung wird vorzugsweise so betrieben, dass die Änderung der kapazitiven Umgebung der Elektrodeneinrichtung eine Änderung der Frequenz des (freilaufenden) LC-Oszillators bewirkt, wobei die Änderung der Frequenz von der Auswerteeinrichtung detektierbar ist. Die Annäherung eines Objekts in den Observationsbereich der Elektrodeneinrichtung führt somit zu einer Änderung der kapazitiven Umgebung dieser Elektrodeneinrichtung, was wiederum zu einer Änderung der Frequenz des Oszillators führt. Durch die Annäherung eines Objekts wird also das Signal des Oszillators frequenzmoduliert, wobei diese Frequenzmodulation von der Auswerteeinrichtung detektierbar ist.

Die Signalgeberschaltung kann auch als Generator ausgebildet sein. Vorzugsweise wird der Generator dann in Resonanz zum LC-Schwingkreis betrieben, was den Vorteil hat, dass auch besonders kleine Kapazitätsänderungen, beispielsweise Kapazitätsänderungen von 1 pF oder kleiner, an der Elektrodeneinrichtung feststellbar sind. Die Kapazitätsänderung an der Elektrodeneinrichtung wird in diesem Fall von der Auswerteeinrichtung anhand der Phasenverschiebung des Signals detektiert.

Die Serverschaltung kann vorteilhafterweise auch in Verbindung mit mindestens einer Clientschaltung betrieben werden. Dazu weist die Sensoreinrichtung des Weiteren mindestens eine Clientschaltung auf, mit
- einer zweiten Elektrodeneinrichtung, aufweisend mindestens eine erste Elektrode und mindestens eine zweite Elektrode, und
- einer mit der zweiten Elektrodeneinrichtung gekoppelten Modulationseinrichtung,
wobei das von der Elektrodeneinrichtung der Serverschaltung abgestrahlte elektrische Feld an der ersten Elektrode der zweiten Elektrodeneinrichtung einkoppelbar ist, wobei das angekoppelte elektrische Feld durch die Modulationseinrichtung modulierbar ist, wobei das modulierte Signal über die Elektrodeneinrichtung der Serverschaltung, vorzugsweise mittels Lastmodulation, an die Serverschaltung rückführbar ist und wobei das zurückgeführte Signal von der Auswerteeinrichtung detektierbar und auswertbar ist.

Dadurch wird in einer besonders vorteilhaften Ausgestaltung der Erfindung eine Sensoreinrichtung bereitgestellt, welche es erlaubt, die Annäherung eines Objekts an die Elektrodeneinrichtung der Serverschaltung zu detektieren bei gleichzeitiger Modulation des von der Elektrodeneinrichtung der Serverschaltung abgestrahlten Signals durch die Clientschaltung, wobei durch die Auswerteeinrichtung neben der Frequenzmodulation auch die Modulation durch die Clientschaltung detektierbar ist.

Die Annäherung eines Objekts an die zweite Elektrode der zweiten Elektrodeneinrichtung kann eine Modulation des eingekoppelten elektrischen Felds durch die Modulationseinrichtung bewirken. Damit kann die Auswerteeinrichtung neben der Annäherung eines Objekts an die Elektrodeneinrichtung der Serverschaltung auch die Annäherung eines Objekts an die zweite Elektrode der Clientschaltung detektieren. Die Auswerteeinrichtung kann auch das Vorhandensein eines Objektes an der zweiten Elektrode der Clientschaltung detektieren, etwa das Vorhandensein eines Flusensiebes in einem Wäschetrockner.

Die erste Elektrode kann auch durch die Elektrodeneinrichtung der Serverschaltung gebildet werden, sodass eine kapazitive Einkoppelung des elektrischen Feldes der ersten Elektrode der zweiten Elektrodeneinrichtung nicht notwendig ist. Auch in dieser Ausführungsform bewirkt eine Annäherung eines Objektes an die zweite Elektrode der zweiten Elektrodeneinrichtung eine Modulation des von der Elektrodeneinrichtung der Serverschaltung erzeugten elektrischen Feldes.

Die Einkoppelung des elektrischen Felds an der ersten Elektrode der Clientschaltung kann durch Überbrückung erfolgen, wobei die Überbrückung eine Modulation des eingekoppelten elektrischen Felds durch die Modulationseinrichtung bewirkt. Aufgrund der Überbrückungswirkung kann die Clientschaltung in Bezug zur Serverschaltung so angeordnet werden, dass eine Annäherung eines Objekts, insbesondere eines Lebewesens, in den Bereich zwischen der Elektrodeneinrichtung der Serverschaltung und der ersten Elektrode der Clientschaltung detektierbar ist. Bei einer derartigen Anordnung der Clientschaltung gegenüber der Serverschaltung ist die zweite Elektrode der Clientschaltung vorzugsweise mit Masse gekoppelt.

Mit dem eingekoppelten elektrischen Feld kann die Clientschaltung auch mit Energie versorgt werden, sodass eine Clientschaltung ohne eigene Energieversorgung realisierbar ist, was insbesondere hinsichtlich der Größe und des Einsatzfeldes von besonderem Vorteil ist.

Die Modulationseinrichtung ist vorzugsweise so ausgestaltet, dass das eingekoppelte elektrische Feld amplitudenmoduliert wird, wobei die Änderung der Amplitude von der Auswerteeinrichtung detektierbar ist.

Vorzugsweise ist eine Annäherung eines Objekts in den Observationsbereich der Elektrodeneinrichtung der Serverschaltung detektierbar, wobei eine Annäherung des Objekts an die zweite Elektrode der zweiten Elektrodeneinrichtung ebenfalls detektierbar ist.

Besonders bevorzugt ist eine Annäherung eines Objekts in den Observationsbereich der Elektrodeneinrichtung der Serverschaltung zeitlich vor der Annäherung des Objekts an die zweite Elektrode der zweiten Elektrodeneinrichtung detektierbar. Dadurch wird erreicht, dass eine Annäherung eines Objekts an die Sensoreinrichtung erkannt wird noch bevor eine Annäherung des Objekts an die Clientschaltung erkannt wird.

Weitere Einzelheiten und Merkmale der Erfindung ergeben sich aus der nachfolgenden Beschreibung in Verbindung mit der Zeichnung. Es zeigt:
- Fig. 1: einen Grundaufbau eines Schaltplans einer Serverschaltung der erfindungsgemäßen Sensoreinrichtung zur Veranschaulichung der Funktionsweise der Serverschaltung,
- Fig. 2: einen Grundaufbau eines Schaltplans einer erfindungsgemäßen Sensoreinrichtung, welche eine Serverschaltung und eine Clientschaltung umfasst, wobei eine erste Annäherungsvariante eines Objekts an die Sensoreinrichtung gezeigt wird; und
- Fig. 3: einen Grundaufbau eines Schaltplans einer erfindungsgemäßen Sensoreinrichtung mit einer Serverschaltung und einer Clientschaltung, wobei eine zweite Variante einer Annäherung eines Objekts an die Sensoreinrichtung gezeigt ist.

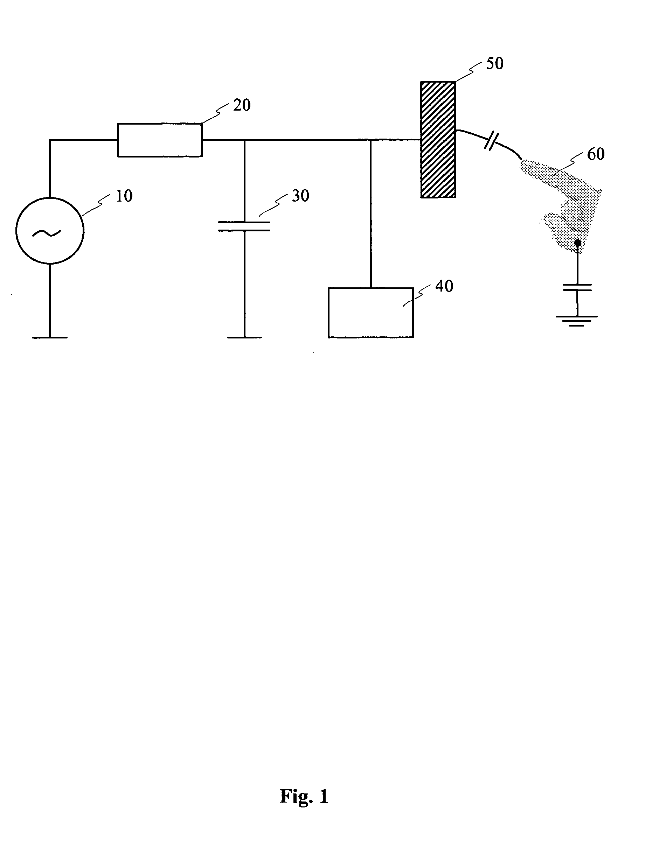

**Fig. 1** zeigt eine Grundschaltung einer Serverschaltung der erfindungsgemäßen Sensoreinrichtung. Die Serverschaltung besteht im Wesentlichen aus einem Generator 10 und einem aus der Induktivität 20 und der Kapazität 30 gebildeten LC-Serienschwingkreis. Der Generator 10, die Induktivität 20 und die Kapazität 30 können hierbei einen freilaufenden LC-Oszillator bilden. Parallel zum LC-Serienschwingkreis liegt eine Serverelektrode 50, sowie eine Auswerteeinrichtung 40.

Der Generator 10 der Serverschaltung erzeugt zunächst eine Wechselspannung, welche dem LC-Serienschwingkreis 20, 30 zugeführt wird, um so den Pegel des Signals zu erhöhen, um anschließend ein elektrisches Feld mit genügend großer Reichweise zu erzeugen. Das erzeugte elektrische Feld wird an einer Elektrode 50 abgegeben, wobei das von der Elektrode 50 abgegebene elektrische Feld den von der Serverschaltung zu observierenden Observationsbereich definiert.

Der LC-Schwingkreis ist vorzugsweise ein Schwingkreis hoher Güte. Das Hauptziel davon ist eine effektive Erhöhung der Spannungsamplitude an der Elektrode 50 sowie eine Erhöhung der Empfindlichkeit der Lastmodulation an dieser Elektrode.

Da die Kapazität der Serverelektrode 50 parallel zur Schwingkreiskapazität 30 liegt, ändert sich die Oszillator-Frequenz mit der Änderung der kapazitiven Umgebung der Serverelektrode 50. Die Änderung der Elektrodenkapazität der Elektrode 50 liegt gewöhnlich im Bereich zwischen 1 bis 100 pF. Eine solche Änderung führt zu einer nennenswerten Änderung der Oszillator-Frequenz, beispielsweise zu einer Änderung zwischen 0,1 und 10 kHz.

Die Auswerteeinrichtung ist so ausgestaltet, dass sie die Änderung der Oszillator-Frequenz detektieren kann und somit eine Annäherung eines Objekts 60, insbesondere eines Lebewesens, an die Elektrode 50 erkennen kann. Die Annäherung eines Lebewesens 60 ist in Fig. 1 schematisch mit einer Hand dargestellt, wobei durch die Annäherung an die Serverelektrode 50 das von dieser abgestrahlte Feld durch das Objekt 60 teilweise absorbiert wird, was zu einer Änderung der kapazitiven Umgebung der Serverelektrode 50 führt.

Die Auswerteeinrichtung 40 kann beispielsweise so ausgestaltet sein, dass sie die Frequenzänderung des vom LC-Oszillator erzeugten Signals mit einem Referenzsignal, welches beispielsweise von einem quarzstabilisierten Oszillator erzeugt wird, vergleicht. Das Vergleichen der Frequenz des Oszillatorsignals mit der Frequenz des Referenzsignals kann mit unterschiedlichen aus dem Stand der Technik bekannten Mitteln erfolgen. Der quarzstabilisierte Oszillator kann aber auch als Takt für einen Zähler eingesetzt werden, wobei der Zähler innerhalb einer vorbestimmten Anzahl von Takten die Frequenz des Oszillatorsignals misst. Mit zeitlich aufeinander folgenden Messungen innerhalb mehrerer Zeitintervalle von gleicher Taktlänge kann bestimmt werden, ob sich die Frequenz des Oszillatorsignals ändert oder nicht.

Aufgrund des erfindungsgemäßen Aufbaus der Serverschaltung mit einem Generator und einem LC-Serienschwingkreis können temperaturbedingte Frequenzänderungen der Serverschaltung effizient erkannt werden, da die Größenordnung einer temperaturbedingten Änderung der Oszillator-Frequenz aufgrund der großen Zeitkonstante einer Temperaturänderung sehr viel kleiner ist als eine Änderung, welche durch eine Annäherung eines Objekts an die Serverelektrode 50 bedingt ist.

Die Induktivität 20 und die Kapazität 30 können auch von einem Generator 10 mit fester Frequenz angeregt werden, wobei hier die Detektion einer Annäherung anhand der Phasenverschiebung des Signals erfolgt. Besonders vorteilhaft ist es dabei, wenn der Generator 10 in Resonanz zum LC-Schwingkreis betrieben wird.

Die erfindungsgemäße Serverschaltung ermöglicht es auch, dass besonders kleine Kapazitätsänderungen von beispielsweise 1 pF oder kleiner innerhalb sehr kurzer Zeit, beispielsweise innerhalb von 10 ms direkt von der Serverschaltung bzw. von der Auswerteeinrichtung detektiert werden. Längere Messintervalle erlauben darüber hinaus auch die Detektion von sehr kleinen, durch die Kapazitätsänderung an der Elektrode hervorgerufenen Frequenzänderungen.

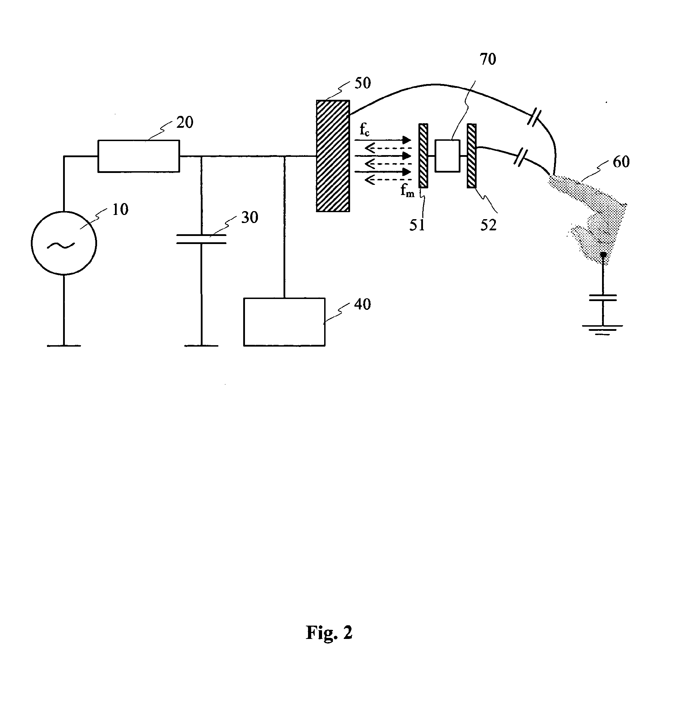

**Fig. 2** zeigt eine weitere vorteilhafte Ausgestaltung einer erfindungsgemäßen Sensoreinrichtung. Die Serverschaltung ist dabei wie in Fig. 1 gezeigt aufgebaut. Zusätzlich weist die Sensoreinrichtung eine Clientschaltung auf. Die Clientschaltung besteht im Wesentlichen aus einer Elektrodeneinrichtung mit zwei Elektroden 51 und 52 sowie einer Modulationseinrichtung 70, wobei die Elektroden 51, 52 jeweils mit der Modulationseinrichtung 70 gekoppelt sind.

Das von der Serverschaltung erzeugte und an der Serverelektrode 50 abgegebene elektrische Feld f_{c} wird an der ersten Elektrode 51 der Clientschaltung eingekoppelt. Dieses eingekoppelte Feld kann gleichzeitig auch dazu benutzt werden, die Clientschaltung mit Energie zu versorgen. Das eingekoppelte elektrische Feld f_{c} wird von der Modulationseinrichtung 70 moduliert. Das modulierte Signal fₘ wird über die Serverelektrode 50, vorzugsweise mittels Lastmodulation, an die Serverschaltung zurückgeführt, wo es der Auswerteeinrichtung 40 zugeführt wird.

Die von der Modulationseinrichtung 70 der Clientschaltung vorgenommene Modulation des Signals wird von der Auswerteeinrichtung 40 ausgewertet. Das elektrische Feld wird hierbei von der Clientschaltung bzw. von der Modulationseinrichtung 70 amplitudenmoduliert.

Nähert sich, wie in Fig. 2 gezeigt, ein Objekt der zweiten Elektrode 52 führt dies dazu, dass sich der Pegel der Modulationseinrichtung ändert, was zu einer geänderten Amplitude des modulierten elektrischen Felds führt. Diese geänderte Amplitude wird von der Auswerteeinrichtung 40 detektiert und ausgewertet.

Gleichzeitig kann eine Annäherung eines Objekts an die Clientschaltung dazu führen, dass auch ein Teil des von der Serverelektrode 50 abgestrahlten elektrischen Felds durch das Objekt absorbiert wird. Die Absorption des elektrischen Felds wiederum führt dazu, wie bereits oben zu Fig. 1 beschrieben, dass sich die Frequenz des von der Serverelektrode 50 abgestrahlten Signals ändert. In diesem Fall wird der Auswerteeinrichtung 40 sowohl ein frequenzmoduliertes als auch amplitudenmoduliertes Signal zugeführt. Dadurch ist sowohl eine Annäherung eines Objekts an die Serverelektrode 50 als auch an die Elektrode 52 der Clientschaltung detektierbar.

Bei entsprechender Anordnung der Clientschaltung gegenüber der Serverelektrode 50 kann eine Annäherung eines Objekts an die Serverelektrode 50 erkannt werden, noch bevor die Annäherung des Objekts an die Clientschaltung erkannt wird.

Dies kann beispielsweise bei einer Bedienblende eines Geräts, etwa für eine Waschmaschine, vorteilhaft eingesetzt werden. Weist die Bedienblende eines Geräts mehrere Clientschaltungen auf, wobei jeder Clientschaltung eine besondere Aktion zugeordnet sein kann, und wobei ein Teil der Bedienblende als Serverelektrode 50 ausgebildet ist, kann die Annäherung einer Hand an die Bedienblende noch vor dem Betätigen bzw. vor der Annäherung der Hand an die Clientschaltung detektiert werden. Die frühzeitige Erkennung der Annäherung eines Objekts an die Serverschaltung bzw. Serverelektrode 50 hat den besonderen Vorteil, dass beispielsweise notwendige Initialisierungsmaßnahmen bereits durchgeführt werden können, noch bevor die Hand die Elektrode 52 der Clientschaltung erreicht.

Ein weiteres Beispiel für den Einsatz der erfindungsgemäßen Sensoreinrichtung ist der Einsatz in einem Wäschetrockner. Wenn ein Teil der Serverelektrode 50 mit dem Innern der Trommel in (schwacher) kapazitiver Koppelung steht, kann eine "Kind in der Trommel"-Detektion oder "Trommelrotationsdetektion" (bei Verwendung von leitfähigen Liftern) anhand der Messung der Frequenzänderung des Oszillators 10 der Serverschaltung erfolgen. Gleichzeitig kann aber auch ein Teil der Serverelektrode 50 dazu verwendet werden, eine Clientschaltung wie in Fig. 2 gezeigt zu betreiben.

Ein weiteres Beispiel für den Einsatz der erfindungsgemäßen Sensoreinrichtung ist etwa der Einbau der Serverelektrode 50 und einer oder mehrerer Clientschaltungen in einen Autositz zum Zweck einer Sitzbelegungserkennung. Hier wird der Vorteil der erfindungsgemäßen Ausgestaltung der Sensoreinrichtung besonders deutlich. Es ist möglich, zwischen einer echten Betätigung der Clientschaltung (was zu einer Amplitudenmodulation des Signals führt) und einem erhöhten Pegel des Signals, welcher durch einen sich auf den Sitz setzenden Menschen bedingt ist, zu unterscheiden. Im zweiten Fall ist neben der Pegeländerung des Signals auch eine besonders große Frequenzänderung vorhanden.

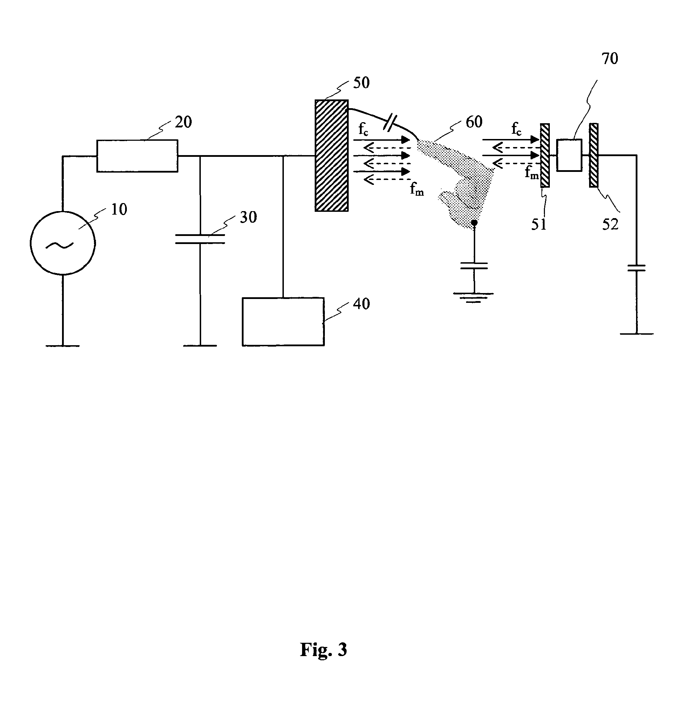

**Fig. 3** zeigt eine weitere vorteilhafte Ausgestaltung der erfindungsgemäßen Sensoreinrichtung. Auch hierbei ist die Serverschaltung wie in Fig. 1 gezeigt ausgebildet. Die Clientschaltung entspricht im Wesentlichen ebenfalls der Clientschaltung aus Fig. 2, mit dem Unterschied, dass die Elektrode 52 kapazitiv gegen Masse gekoppelt ist. Die Clientschaltung ist so gegenüber der Serverschaltung angeordnet, dass das an der Elektrode 50 abgestrahlte elektrische Feld nur dann an der Elektrode 51 der Clientschaltung eingekoppelt wird, wenn sich ein leitfähiges Objekt, beispielsweise eine Hand, zwischen der Elektrode 50 und der Elektrode 51 befindet. Das an der Elektrode 50 abgestrahlte Signal wird dabei von den sich zwischen Clientschaltung und der Serverschaltung befindlichen Objekt von der Elektrode 50 auf die Elektrode 51 übertragen (d.h. das elektrische Feld wird durch die Überbrückungswirkung des leitfähigen Objektes an der Elektrode 51 eingekoppelt).

Ebenso erfolgt die Übertragung des durch die Clientschaltung bzw. der Modulationseinrichtung 70 modulierten Signals über das zwischen den beiden Elektroden angeordnete Objekt. Auch hierbei ist das von der Clientschaltung erzeugte Signal amplitudenmoduliert.

Wie bereits in Fig. 2 beschrieben, bewirkt auch nach der Ausführungsform gemäß Fig. 3 eine Annäherung eines Objekts an die Serverelektrode 50 eine Absorption eines Teils des von der Serverelektrode 50 abgestrahlten elektrischen Felds. Die Absorption führt auch hier zu einer Änderung der Frequenz des Oszillatorsignals. Somit kann auch in dieser Ausführungsform, bei entsprechender Anordnung der Clientschaltung gegenüber der Serverschaltung, etwa wie in Fig. 3 gezeigt, die Annäherung eines Objekts an die Serverelektrode 50 erkannt werden, noch bevor das Objekt eine Überbrückungswirkung zur Einkoppelung des elektrischen Felds der Serverelektrode 50 an die Elektrode 51 bewirkt.

Die Auswerteeinrichtung 40 ist auch hier so ausgestaltet, dass sie sowohl die Annäherung eines Objekt an die Serverelektrode 50 (Frequenzänderung) als auch das Einkoppeln des elektrischen Felds an die Elektrode 51 (Amplitudenänderung) detektieren und auswerten kann.

Die Serverschaltung der erfindungsgemäßen Sensoreinrichtung ist somit derart ausgestaltet, dass die Serverschaltung allein (d.h. ohne Zusammenwirken mit einer Clientschaltung) als Annäherungssensor verwendbar ist, gleichzeitig aber auch zusammen mit einer oder mehreren Clientschaltungen ein Sensornetzwerk realisierbar ist, wobei die Clientschaltungen vorzugsweise mit dem elektrischen Feld der Serverelektrode 50 mit Energie versorgt werden. Der Aufbau eines Sensometzwerkes mit einer Serverschaltung und mehreren Clientschaltungen kann beispielsweise so erfolgen, dass die Auswerteeinrichtung der Serverschaltung die einzelnen Clientschaltungen unterscheiden kann.

## Patentansprüche

1. Sensoreinrichtung zur Erfassung einer Annäherung eines Objektes in einen von der Sensoreinrichtung überwachten Observationsbereich, aufweisend
- eine Serverschaltung mit
- einem LC-Schwingkreis (20, 30) mit einer Signalgeberschaltung (10), vorzugsweise einem LC-Schwingkreis hoher Güte, zur Erzeugung eines elektrischen Feldes (fc);
- einer mit dem LC-Schwingkreis gekoppelten Elektrodeneinrichtung (50), wobei die Kapazität der Elektrodeneinrichtung Bestandteil der Schwingkreiskapazität (30) bildet und wobei das vom LC-Schwingkreis erzeugte elektrische Feld (fc) an der Elektrodeneinrichtung in den Observationsbereich abstrahlbar ist; und
- einer Auswerteeinrichtung (40);
wobei die Annäherung eines Objektes (60) in den Observationsbereich der Elektrodeneinrichtung (50) der Serverschaltung eine Änderung der kapazitiven Umgebung der Elektrodeneinrichtung (50) der Serverschaltung bewirkt, welche von der Auswerteinrichtung (40) detektierbar ist;
und
- mindestens eine Clientschaltung mit
- einer zweiten Elektrodeneinrichtung, aufweisend mindestens eine erste Elektrode (51) und mindestens eine zweite Elektrode (52); und
- einer mit der zweiten Elektrodeneinrichtung gekoppelten Modulationseinrichtung (70);
wobei das von der Elektrodeneinrichtung (50) der Serverschaltung abgestrahlte elektrische Feld (fc) an der ersten Elektrode (51) der zweiten Elektrodeneinrichtung einkoppelbar ist, wobei das eingekoppelte elektrische Feld (fc) durch die Modulationseinrichtung (70) modulierbar ist, wobei das modulierte Signal (fm) über die Elektrodeneinrichtung (50) der Serverschaltung, vorzugsweise mittels Lastmodulation, an die Serverschaltung zurückführbar ist, wobei das zurückgeführte Signal von der Auswerteinrichtung (40) detektierbar und auswertbar ist, und wobei die Annäherung des Objektes (60) an die zweite Elektrode (52) der zweiten Elektrodeneinrichtung eine Modulation des eingekoppelten elektrischen Feldes (fc) durch die Modulationseinrichtung bewirkt.

2. Sensoreinrichtung nach Anspruch 1, wobei die Signalgeberschaltung einen Oszillator umfasst.

3. Sensoreinrichtung nach einem der vorgehenden Ansprüche, wobei der LC-Schwingkreis ein LC-Serienschwingkreis ist und wobei die Elektrodeneinrichtung (50) der Serverschaltung parallel zum LC-Serienschwingkreis geschaltet ist.

4. Sensoreinrichtung nach einem der Ansprüche 1 oder 2, wobei der LC-Schwingkreis ein LC-Parallelschwingkreis ist und wobei die Elektrodeneinrichtung (50) der Serverschaltung seriell zum LC-Parallelschwingkreis geschaltet ist.

5. Sensoreinrichtung nach einem der Ansprüche 2 oder 3, wobei die Änderung der kapazitiven Umgebung der Elektrodeneinrichtung (50) der Serverschaltung eine Änderung der Frequenz des freilaufenden LC-Oszillators bewirkt, wobei die Änderung der Frequenz von der Auswerteinrichtung (40) detektierbar ist.

6. Sensoreinrichtung nach Anspruch 1, wobei die Signalgeberschaltung (10) ein Generator ist, wobei der Generator vorzugsweise in Resonanz zum LC-Schwingkreis betrieben wird und wobei eine Änderung der kapazitiven Umgebung der Elektrodeneinrichtung (50) der Serverschaltung eine Phasenverschiebung des Generatorsignals bewirkt.

7. Sensoreinrichtung nach einem der vorhergehenden Ansprüche, wobei die Einkoppelung des elektrischen Feldes (fc) durch Überbrückung erfolgt und wobei die Überbrückung eine Modulation des eingekoppelten elektrischen Feldes (fc) durch die Modulationseinrichtung (70) bewirkt.

8. Sensoreinrichtung nach einem der vorhergehenden Ansprüche, wobei die Modulationseinrichtung (70) das eingekoppelte elektrische Feld (fc) amplitudenmoduliert und wobei die Änderung der Amplitude von der Auswerteinrichtung (40) detektierbar ist.

9. Sensoreinrichtung nach einem der vorhergehenden Ansprüche, wobei eine Annäherung eines Objektes in den Observationsbereich der Elektrodeneinrichtung (50) der Serverschaltung zeitlich vor der Annäherung des Objektes an die zweite Elektrode (52) der zweiten Elektrodeneinrichtung detektierbar ist.

10. Sensoreinrichtung nach einem der vorhergehenden Ansprüche, wobei die Clientschaltung mit dem von der Serverschaltung erzeugten elektrischen Feld (fc) mit Energie versorgbar ist.

11. Sensoreinrichtung nach einem der vorhergehenden Ansprüche, wobei die erste Elektrode (51) der zweiten Elektrodeneinrichtung durch die Elektrodeneinrichtung (50) der Serverschaltung gebildet wird.

## Claims

1. A sensor device for detecting an approach of an object into an observation area monitored by the sensor device, comprising
- a server circuit comprising
- an LC oscillating circuit (20, 30) comprising a signal generator circuit (10), preferably an LC oscillating circuit of high Q factor, for generating an electric field (fc);
- an electrode device (50) coupled with the LC oscillating circuit, wherein the capacitance of the electrode device forms a component of the oscillating circuit capacitance (30) and wherein the electric field (fc) generated by the LC oscillating circuit at the electrode device may be emitted into the observation area; and
- an evaluation device (40);
wherein the approach of an object (60) into the observation area of the electrode device (50) of the server circuit causes a variation oft he capacitive surrounding area of the electrode device (50) of the server circuit, which may be detected by the evaluation device (40); and
- at least one client circuit comprising
- a second electrode device, having at least one first electrode (51) and at least one second electrode (52); and
- a modulation device (70) coupled with the second electrode device;
wherein the electric field (fc) emitted by the electrode device (50) of the server circuit may be coupled in at the first electrode (51) of the second electrode device, wherein the coupled electric field (fc) may be modulated by means of the modulation device (70), wherein the modulated signal (fm) may be returned to the server circuit via the electrode device (50) of the server circuit, preferably by means of load modulation, wherein the returned signal may be detected and evaluated by means of the evaluation device (40), and wherein the approach of the object (60) towards the second electrode (52) of the second electrode device causes a modulation of the coupled electric field (fc) by means of the modulation device.

2. The sensor device of claim 1, wherein the signal generator circuit comprises an oscillator.

3. The sensor device of one of the preceding claims, wherein the LC oscillating circuit is a LC serial oscillating circuit and wherein the electrode device (50) of the server circuit is wired parallel to the LC serial oscillating circuit.

4. The sensor device of one of claims 1 or 2, wherein the LC oscillating circuit is a LC parallel oscillating circuit and wherein the electrode device (50) of the server circuit is wired in series with the LC parallel oscillating circuit.

5. The sensor device of one of claims 2 or 3, wherein the variation of the capacitive surrounding area of the electrode device (50) of the server circuit causes a variation of the frequency of the free-running LC oscillating circuit, wherein the variation of the frequency may be detected by means of the evaluation device (40).

6. The sensor device of claim 1, wherein the signal generator circuit (10) is a generator, wherein the generator preferably is operated in feedback with the LC oscillating circuit and wherein a variation of the capacitive surrounding area of the electrode device (50) of the server circuit causes a phase shift of the generator signal.

7. The sensor device of one of the preceding claims, wherein the coupling of the electric field (fc) is carried out by bridgeover and wherein the bridgeover causes a modulation of the coupled electric field (fc) by means of the modulation device (70).

8. The sensor device of one of the preceding claims, wherein the modulation device (70) modulates the coupled electric field (fc) in its amplitude and wherein the variation of the amplitude may be detected by means of the evaluation device (40).

9. The sensor device of one of the preceding claims, wherein an approach of an object into the observation area of the electrode device (50) of the server circuit may be detected temporally before the approach of the object towards the second electrode (52) of the second electrode device.

10. The sensor device of one of the preceding claims, wherein the client circuit may be supplied with energy by the electric field (fc) generated by the server circuit.

11. The sensor device of one of the preceding claims, wherein the first electrode (51) of the second electrode device is formed by the electrode device (50) of the server circuit.

## Revendications

1. Dispositif de détection pour percevoir l'approche d'un objet dans une zone d'observation surveillée par le dispositif de détection, présentant
- un circuit serveur avec
- un circuit oscillant LC (20, 30) avec un circuit émetteur de signaux (10), de préférence un circuit oscillant LC de haute qualité, pour produire un champ électrique (fc) ;
- un dispositif d'électrode (50) couplé au circuit oscillant LC, dans lequel la capacité du dispositif d'électrode fait partie de la capacité (30) du circuit oscillant et dans lequel le champ électrique (fc) produit par le circuit oscillant LC peut être diffusé sur le dispositif d'électrode dans la zone d'observation ; et
- un dispositif d'interprétation (40) ;
dans lequel l'approche d'un objet (60) dans la zone d'observation du dispositif d'électrode (50) du circuit serveur produit une modification de l'environnement capacitif du dispositif d'électrode (50) du circuit serveur, laquelle peut être détectée par le dispositif d'interprétation (40) ;
et
- au moins un circuit client avec
- un deuxième dispositif d'électrode, présentant au moins une première électrode (51) et au moins une deuxième électrode (52) ; et
- un dispositif de modulation (70) couplé au deuxième dispositif d'électrode ;
dans lequel le champ électrique (fc) diffusé par le dispositif d'électrode (50) du circuit serveur peut être injecté sur la première électrode (51) du deuxième dispositif d'électrode, dans lequel le champ électrique injecté (fc) peut être modulé par le dispositif de modulation (70), dans lequel le signal modulé (fm) peut être renvoyé au circuit serveur via le dispositif d'électrode (50) du circuit serveur, de préférence par modulation de charge, dans lequel le signal renvoyé peut être détecté et interprété par le dispositif d'interprétation (40), et dans lequel l'approche de l'objet (60) de la deuxième électrode (52) du deuxième dispositif d'électrode produit une modulation, via le dispositif de modulation, du champ électrique injecté (fc).

2. Dispositif de détection selon la revendication 1, dans lequel le circuit émetteur de signaux comprend un oscillateur.

3. Dispositif de détection selon l'une des revendications précédentes, dans lequel le circuit oscillant LC est un circuit oscillant LC en série, et dans lequel le dispositif d'électrode (50) du circuit serveur est monté en parallèle du circuit oscillant LC en série.

4. Dispositif de détection selon l'une des revendications 1 ou 2, dans lequel le circuit oscillant LC est un circuit oscillant LC en parallèle, et dans lequel le dispositif d'électrode (50) du circuit serveur est monté en série avec le circuit oscillant LC parallèle.

5. Dispositif de détection selon l'une des revendications 2 ou 3, dans lequel la modification de l'environnement capacitif du dispositif d'électrode (50) du circuit serveur produit une modification de la fréquence de l'oscillateur LC à fonctionnement libre, dans lequel la modification de la fréquence peut être détectée par le dispositif d'interprétation (40).

6. Dispositif de détection selon la revendication 1, dans lequel le circuit émetteur de signaux (10) est un générateur, dans lequel le générateur est opéré de préférence en résonance avec le circuit oscillant LC, et dans lequel une modification de l'environnement capacitif du dispositif d'électrode (50) du circuit serveur produit un déphasage du signal du générateur.

7. Dispositif de détection selon l'une des revendications précédentes, dans lequel l'injection du champ électrique (fc) s'effectue par pontage, et dans lequel le pontage produit une modulation, via le dispositif de modulation (70), du champ électrique injecté (fc).

8. Dispositif de détection selon l'une des revendications précédentes, dans lequel le dispositif de modulation (70) module en amplitude le champ électrique injecté (fc), et dans lequel la modification de l'amplitude peut être détectée par le dispositif d'interprétation (40).

9. Dispositif de détection selon l'une des revendications précédentes, dans lequel une approche d'un objet dans la zone d'observation du dispositif d'électrode (50) du circuit serveur peut être détectée dans le temps avant que l'objet n'approche de la deuxième électrode (52) du deuxième dispositif d'électrode.

10. Dispositif de détection selon l'une des revendications précédentes, dans lequel le circuit client peut être alimenté en énergie par le champ électrique (fc) produit par le circuit serveur.

11. Dispositif de détection selon l'une des revendications précédentes, dans lequel la première électrode (51) du deuxième dispositif d'électrode est formée par le dispositif d'électrode (50) du circuit serveur.
